# EUROPEAN PATENT SPECIFICATION

(11) **EP 2 406 640 B1**
(45) Date of publication and mention of the grant of the patent: **08.01.2014**
(21) Application number: 10712468.7
(22) Date of filing: 10.03.2010
(51) Int. Cl.: G01R 15/20

(54) **CURRENT SENSING AND/OR MEASUREMENT - APPARATUS AND METHOD**
VORRICHTUNG UND VERFAHREN ZUR STROMERFASSUNG UND/ODER MESSUNG
APPAREIL ET PROCÉDÉ DE DÉTECTION ET/OU DE MESURE DE COURANT

(30) Priority: 14.03.2009 GB 0904441
(43) Date of publication of application: 18.01.2012
(73) Proprietor: GMC-I Prosys Ltd., Lancashire WN8 9PH (GB)
(72) Inventor: EBENEZER, Desmond, Nullan, Lancashire WN8 9PH (GB); MARSH, David, John, Lancashire WN8 9PH (GB); JACYNA, Geoffrey, Lancashire WN8 9PH (GB)
(74) Representative: Stevenson-Hill, Jack Patrick
(86) International application number: PCT/GB2010/000431
(87) International publication number: WO 2010/106304

(56) References cited:
- EP-A1- 1 855 119
- EP-B1- 0 740 796
- DE-A1-102007 035 184
- US-A1- 2005 156 587

## Description

### Introduction

The present invention relates to apparatus devices and methods for sensing and/or measuring electrical currents flowing through wires or cables in a non-invasive manner by means of detection of the magnetic filed resulting from the flow of current.

### Background

Magnetic field sensors, such as Hall effect sensors and flux gates, have been used for non-invasive measurement and sensing of electric current flow by detection of the magnetic field generated around a wire or cable carrying the current. Typically, the magnetic field to be detected is relatively weak, and stray magnetic field, such as the earth's magnetic field, may interfere with the detection and measurement of the magnetic field arising from the current to be measured.

DE-A- 3 817 299 discloses a magnetic sensor arrangement which is part of a current sensing device having means for fitting around an electrical conductor whose current is to be measured. The current sensor element is located in a recess within a core material, and is covered by an earth element and a cover plate.

EP-A-0 740 796 discloses magnetic field sensors and, particularly, a magnetic field sensor arrangement for use in an electrical current measuring device. In the device, magnetic field sensors are provided within recesses formed in arms of the device. The recesses are typically formed within laminated arms of high magnetic permeability, which act to shield the magnetic field sensors from interference from external magnetic fields, whilst enabling them to detect a magnetic field of an electrical conductor enclosed by the arms. The end faces of the arms are exposed such that the arms, in a closed position, form a continuous loop of high permeability material to shield the sensors from magnetic interference from stray fields such as the earth's magnetic field.

In practice, with such a device, it is extremely difficult to achieve adequate close contact between the end faces of the shielding arms to give a sufficiently low reluctance at the ends such that any external magnetic fields may stray into the recesses as fringe fields. A variable reluctance between the ends of the arms of the device, the value of which will depend upon how well the arms are pressed together, may lead to variation in the strength of such fringe fields. It has been found that such a small yet variable gap may lead to a fringe field from the external stray magnetic fields entering the recesses holding the magnetic field sensors, where it may be detected by the magnetic field sensors, causing errors in the estimated value of the current deduced from the output of the magnetic field sensors. This is because the magnetic field sensed includes not only the field generated by the current in the cable enveloped by the arms, but also any fringe magnetic fields leaking through the ends of the arms.

A further problem is that the high permeability material of the arms, in addition to acting to partially shield the magnetic sensors from stray magnetic fields may also act as a low reluctance shunt through which the field generated by the current to be measured will be diverted rather than passing through the magnetic sensors. In other words, in addition to diverting stray external magnetic fields away from the magnetic field sensors, the magnetic circuit formed by the arms may also divert the magnetic field generated by the current, to be sensed and/or measured, away from the magnetic field sensors. This may result in considerable attenuation of the field to be measured by the magnetic sensors, leading to reduction in the sensitivity of the device and inaccuracies when measuring low currents.

Hence there is a need for a current sensing or measuring methods and apparatus that address or overcome some or all of these problems in the prior art. In particular, there is a need for methods and apparatus that provide high sensitivity to low currents without interference from stray magnetic fields.

### Summary of Invention

One object of the present invention, amongst others, is to provide methods and apparatus for indirect sensing and/or measurement of a current in a wire or cable, without direct electrical contact with the current, and with improved sensitivity to low currents.

A first aspect of the invention provides a current sensing assembly comprising first and second arms of a first magnetically permeable material,
each having first and second ends,
the arms being configured to be movable from an open configuration to a closed configuration,
wherein, in the closed configuration, the first ends of each arm are positioned at a first joint and the second ends of each arm are positioned at a second joint,
and wherein in the closed configuration, the arms and joints co-operate to form a substantially closed magnetic circuit defining an inner region enclosed by the magnetic circuit suitable for accepting a cable in which an electrical current is to be sensed and/or measured,
wherein a first magnetic field sensor is located in a first housing at the first joint, and the first joint is provided with a cuff of a second magnetically permeable material arranged and positioned to substantially enclose the first joint, when in the closed configuration, and to shield the first magnetic field sensor from magnetic fields originating outside the inner region.

Preferably, a second magnetic field sensor is located in a second housing at the second joint, the second joint being provided with a second cuff of the second magnetically permeable material arranged and positioned to substantially enclose the second joint, when in the closed configuration, and to shield the second magnetic field sensor from magnetic fields originating outside the inner region.

A second aspect of the invention provides a current sensing device comprising a current sensing assembly according to the first aspect of the invention.

A third aspect of the invention provides a method for sensing and/or measuring a current in a cable comprising: configuring the cable to pass through the inner region of a current sensing assembly or device according to the first or second aspects of the invention and sensing and/or measuring the magnetic field generated by the current using the first and optionally second magnetic field sensor, whereby the current is sensed and/or measured.

### Detailed Description of Invention

The first aspect of the invention provides a current sensing assembly having two arms, which are configurable to surround or envelop a wire or cable carrying electrical current in an inner space or region enveloped by the arms when the ends of the arms are brought together at first and second joints. A first magnetic field sensor is located in a first housing at the first joint, and preferably a second magnetic sensor is located in a second housing at the second joint. The use of two sensors, typically positioned to be on opposed sides of the cable or wire, provides greater precision for the measurement of the magnetic field generated by the current.

Typically, the first and second housings are positioned in the first and second ends of the first arm.

The arms are of a first magnetically permeable material. By "magnetically permeable material" it is meant that the material has a relative permeability (µ/µ₀ where µ is the magnetic permeability of the material, and µ₀ that of free space) of 500 or more, preferably 5000 or more, even more preferably 10000 or more. Suitable magnetically permeable materials for the arms and cuffs include Permalloy, Mumetal, Radiometal and Vacoperm.

Each magnetic field sensor is provided with a cuff of a second magnetically permeable material substantially surrounding the joint in which it is located in a recess. Although the first and second magnetically permeable materials may be the same material, a preferred material for the cuffs is mu-metal because of its high permeability and the ease with which the material may be formed into complex shapes. Such a malleable material is not required for the arms, so the first material may be of a more brittle and less costly nature than that of the cuff. Magnetically permeable laminates may be used for the arms, giving reduction in undesirable heating arising from eddy current generation.

Each cuff will suitably be configured to wrap around its respective joint in order to provide a shield against external magnetic fields. Although the cuff may be slidably mounted on an arm or arms, such that they may be positioned to shield a the joint after the joint has been formed by bringing the arms together around a wire or cable, preferably the first cuff and optional second cuff are each affixed to an end of an arm. In a particularly useful configuration, the first and second cuffs are each affixed to the first and second ends respectively of the first arm. This allows connection wires or circuitry for the magnetic field sensors to be connected to the current sensing assembly by means of the first arm only. For instance the first arm may be firmly mounted in a current sensing device according to the second aspect of the invention with the second arm movable or even removable as no electrical connections are required to the second arm with this configuration.

So that the field generated by the current to be sensed and/or measured reaches the magnetic field sensor, the cuff is suitably arranged such that there is an aperture or opening between the cuff and its respective joint so that the magnetic field generated by the current to be measured will not be entirely shielded from the magnetic sensor. Preferably, there will be an aperture in the cuff positioned to allow the magnetic field generated by the current to be sensed/measured to pass through the cuff to its respective magnetic field detector. Hence, each cuff may enclose its respective joint save for an aperture in the cuff positioned between the respective magnetic field detector and the inner region. This aperture is suitably a slot in the cuff positioned towards the inner region enclosed by the arms when the arms are in their closed configuration. Each cuff will typically be in the form of a cuff wrapped around the arm with the axis of the arm at the cuff substantially forming the axis of the cuff, such that the plane of the magnetic circuit formed by the arms in their closed configuration is substantially normal to the plane of the magnetic circuit formed by the cuff. The slot in the cuff will typically be substantially in the same plane as the magnetic circuit formed by the arms in their closed configuration.

The first and second arms may be formed in any suitable shape for enclosing a cable in the closed configuration. Preferably the 2 arms shall be symmetrical. Typically, each first and second arm is substantially semicircular in plan, such that the inner space or region enclosed by the arms in the closed configuration has a circular cross section. The diameter of the circle may be any suitable diameter depending upon the diameter of cable to pass through the inner region. Preferably, the arms are configured to snugly fit to the cable to be measured. The arms may be completely separated in the open configuration. For instance the first arm may be mounted in a device or tool with the second arm removably attachable to the tool in order to form the first and second joints in the closed configuration. For instance, the second joint may comprise a pivot means such as a hinge or axle whereby the arms are movable from an open configuration to a closed configuration about the pivot means. In this case, the first and second arms will remain connected at the pivot means at the second joint when in the open configuration. The second cuff, if present, will be suitably configured to allow opening and closing of the first and second joints by movement about the pivot means. For instance the second cuff may be slidably mounted on an arm such that it can be slid away from the second joint to allow opening of the hinge and slid back over the second joint when in the closed configuration.

In the closed configuration, the first ends may be in touching contact with each other and the second ends may be in touching contact with each other whereby the magnetic circuit is substantially uninterrupted at the first and second joints. As explained hereinbefore, touching contact at a joint in the magnetic circuit may lead to some variability in the reluctance associated with the joint.

Suitably, in the closed configuration, there may be a first gap between the first ends and a second gap between the second ends of the arms whereby the magnetic circuit comprises first and second reluctances arising from the first and second gaps respectively. By "gap" is meant a region of low magnetic permeability, i.e. having a relative permeability of 100 or less, preferably 10 or less, more preferably 2 or less such as about 1 such that a magnetic reluctance is provided by the gap in the magnetic circuit. This allows the reluctances at the gaps to be more reliably established each time the arms are brought into the closed configuration for a measurement. Suitably, the first and second joints may comprise first and second spacing means arranged to give rise to the first and second gaps in the closed configuration. For example, each end may be provided with a thin layer of low permeability coating, such as a varnish, which provides a known reluctance when the ends are brought together into the closed configuration. Alternatively, the arms may be held in holders with the holders configured such that when the holders are brought into touching contact to form the closed configuration, the first and second gaps are present between the ends of the arms.

Suitably, the first and second reluctances may be arranged to be each 10⁴ Ampere-turns/Weber or more, preferably 10⁵ or more, more preferably 10⁶ or more. This reluctance may be calculated from the formula (L/µA) where L is the width of the gap in metres, µ is the permeability of the material within the gap (typically air or a low permeability coating as detailed above) and A is the cross sectional area of the gap (in m²)

The presence of such a reluctance at each joint in the closed configuration may also results in a higher magnetic field being present, arising from the current to be measured, at the magnetic field sensor in the respective joint, than would be present if there were no gap. This is because there will be no high permeability shunt at the joint to draw the magnetic field, generated by the current to be measured, away from the respective magnetic field sensor. Suitably, the first and optional second housings are each located in an end of an arm and substantially within the respective gaps at the first and second joints.

Any suitable magnetic field sensors may be used with the invention. Typically, the first and second magnetic field sensors may be Hall effect sensors, which generate a sensing current in response to a sensed magnetic field. For instance flux gates may be used as magnetic sensors.

Preferably, the current sensing assembly of the first aspect of the invention comprises a means for generating a compensating magnetic field, driven by a compensation current, within the magnetic circuit whereby a net magnetic field at each magnetic field sensor, originating from the current to be measured in the cable passing through the inner region, combined with the compensating magnetic field, may be minimised such that said current to be measured has a value deducible from the required compensation current value.

In other words, the mean sensing signal from the sensors, such as a mean Hall-effect current derived for instance from the arithmetic mean of the signals from each sensor, may be monitored, and a compensating current driven through the means for generating a compensating magnetic field, the compensating current being increased until the mean sensing signal reaches its minimum value. Circuits and control means for carrying out such a process are well known in the art. The value of the compensating current required to minimise the mean sensing signal may then be used to deduce the value of the current to be measured in the cable or wire encompassed by the arms.

The compensating magnetic field may be generated by a winding (i.e. a wire to carry electrical current wound several times around an arm) around one or both of the arms. Preferably, a winding is positioned on the first arm. This allows connection wires or circuitry for the magnetic field sensors to be connected to the current sensing assembly by means of the first arm only giving the same advantage as mentioned above that the first arm may be firmly mounted in a current sensing device according to the second aspect of the invention with the second arm movable or even removable as no electrical connections are required for the second arm with this configuration.

The second aspect of the invention provides a device or tool including the current sensing assembly of the first aspect of the invention. Suitably, the device or tool comprises an actuating means, such as a trigger or handle configured to move the first and second arms between open and closed configurations. The first and second arms may be suitably biased by a resilient means, such as a spring, towards the closed configuration. The device or tool will suitable comprise holding means for firmly holding the first and second arms relative to each other. The second aspect of the invention may provide a tool to be used for temporary placement of the current sensing assembly around a cable. Alternatively, the second aspect of the invention may provide a permanent installation for monitoring a current passing through a cable. For instance, the device may be fixed in place around a domestic cable in order to measure the current passing through the cable for safety, security or monitoring purposes. The device or tool may include a means for displaying and/or recording the value of current that is monitored by the device. The second aspect of the invention may, for instance, provide a sensing means for the detection of an open circuit by sensing the absence of a current flowing in a cable, or may be used to detect leakage of current to earth by detecting flow of current through an earth wire in an electrical circuit.

The third aspect of the invention provides a method for sensing and/or measuring current as detailed hereinbefore and making use of the sensing assembly or device of the first and second aspects of the invention.

Preferably, the current is measured using a current sensing assembly having a means for generating a compensating magnetic field, driven by a compensation current, within the magnetic circuit, whereby a net magnetic field at each magnetic field sensor, originating from the current to be measured in the cable passing through the inner region, combined with the compensating magnetic field, may be minimised such that said current to be measured has a value deducible from the required compensation current value.

The current value is deduced from the compensating current value required to minimise the net magnetic field at the first and optionally second magnetic field sensor. The sensing assembly, tool or device may be calibrated in order to provide a calibration curve relating the value of the sensed current to the value of the compensating current required to minimise the net magnetic field. The method may include the steps of displaying and/or recording the value of current that is monitored by the device.

### Brief Description of Figures

Specific embodiments of the present invention will now be described, by way of example only, with reference to the accompanying drawings in which:
Figure 1 shows a first embodiment of the invention in perspective view,
Figure 2 shows a plan view of the first arm of the first embodiment,
Figure 3 shows a cross-sectional side view of the first embodiment, in its closed configuration, showing a reluctance gap at each joint,
Figure 4 shows a detailed side perspective cross-sectional view of one of the joints of Figure 3, showing a reluctance gap between the first and second arms of the first embodiment in the closed configuration,
Figure 5 shows a cross-sectional side view of a second embodiment of the invention in its closed configuration, as for the first embodiment but having no reluctance gaps at the joints,
Figure 6 shows a detailed side perspective cross-sectional view of one of the joints of figure 5 in the closed configuration,
Figure 7 shows a side perspective view of a third embodiment of the invention in its closed configuration, the embodiment having a compensation coil on the first arm,
Figure 8 shows a side view of the first arm of the third embodiment,
Figure 9 shows a plan view of the first arm of the third embodiment,
Figure 10 shows a side perspective view of the first arm of the third embodiment, and
Figure 11 shows a side perspective view of the second arm of the third embodiment.

### Detailed Description of Figures

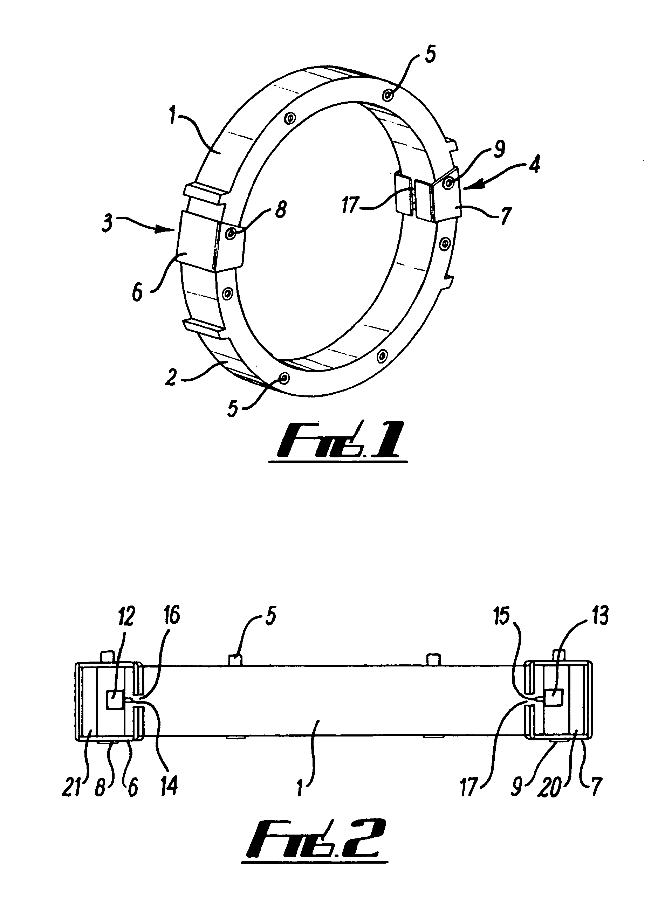

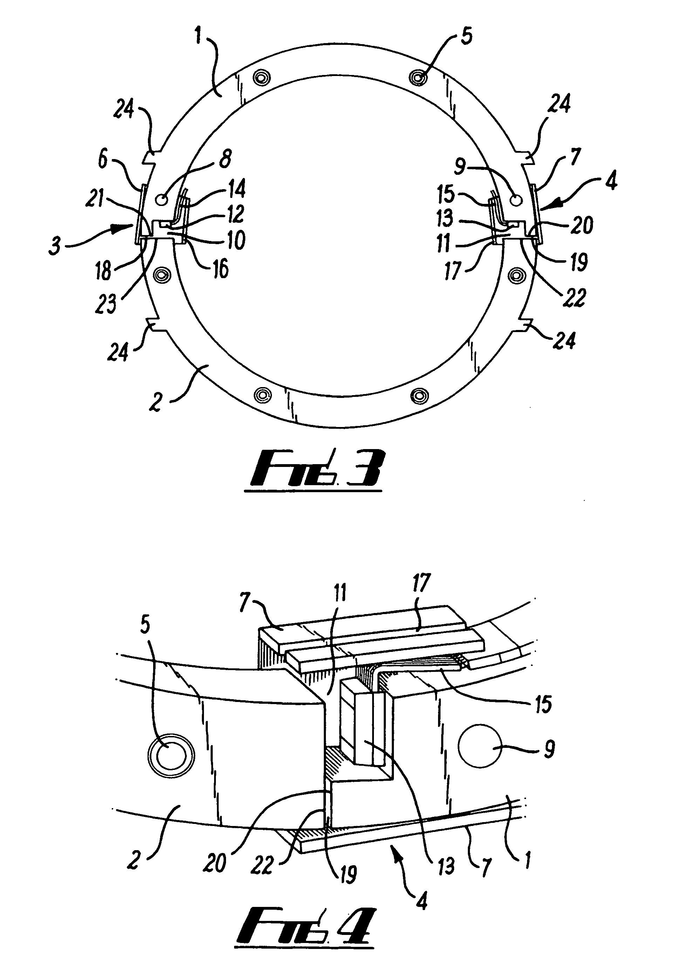

Turning to Figures 1 to 4, these show a first embodiment of the current sensing assembly of the first aspect of the invention. First 1 and second 2 arms are configured to be movable from an open configuration to a closed configuration and are shown in the closed configuration in figures 1, 3 and 4. First 3 and second 4 joints are formed between the respective first and second ends of the arms. The first 1 and second 2 arms are formed of a laminated material of high magnetic permeability such as Permalloy. The laminate sheets forming each arm are separated by layers of a non-permeable coating to reduce eddy current heating and are held together by rivets 5. At each end of the first arm 1 cuffs 6, 7 are attached towards each end of the first arm 1 by rivets 8, 9 passing through the cuffs and through the arm 1. The cuffs 6, 7 are of a highly magnetically permeable material such as mu-metal. Housings 10, 11 are present at each joint 3, 4 formed in each end of the arm 1. Magnetic field sensors 12, 13, which are Hall effect sensors in this embodiment, are located in each housing 10, 11. Electrical leads 14, 15 connected to the magnetic sensors 12, 13 allow the magnetic field within the housing to be sensed and/or measured by means of signals (current or voltage) transmitted from the sensors 12, 13 to a measurement apparatus operably connected to the leads 14, 15. The measurement apparatus connected to the electrical leads is not shown in the figures.

In the closed configuration, each cuff 6, 7 substantially surrounds its respective joint 3, 4 and also surrounds the housing 10, 11 containing the magnetic sensor 12, 13. An aperture 16, 17 is provided in each cuff 6, 7 such that there is a direct pathway between the magnetic sensors 13, 14, and the inner region enclosed by the arms 1, 2 in the closed configuration, through each respective aperture 16, 17. This allows the magnetic field generated by an electric current in a cable passing through the inner region of the arms in their closed configuration to be sensed and/or measured by the magnetic sensors 12, 13. When the arms 1, 2 are in the closed configuration, gaps 18, 19 are present between the ends 20, 21 of the first arm and the ends 22, 23 of the second arm in this embodiment. Lugs 24 are provided on each arm 1, 2 in order to allow the arms to be firmly fixed to holders (not shown) which hold the arms. The closed configuration is made by bringing the holders, holding the arms, into touching contact with each other whereby gaps 18, 19 remain at the ends of each arm 1, 2 in the closed configuration.

In use, the arms 1, 2 in their respective holders are brought from an open configuration to hold the arms 1,2 in the closed configuration with the arms forming an inner region encircling a cable in which a current is to be sensed and/or measured. The magnetic field generated by the current passes through the apertures 16, 17 in the cuffs 6, 7 to the magnetic sensors 12, 13 where it is detected and a detection signal sent along the cables 14, 15 to a sensing apparatus (not shown). The cuffs 6, 7 shield the magnetic sensors 12, 13 in their respective housings 10, 11 from any external stray magnetic fields. The gaps 18, 19 at each joint between the first and second arms 1, 2 ensure that the magnetic field to be sensed from the cable is not short circuited through a circuit formed between the arms 1, 2. Any stray external fields will pass through the arms rather than entering the inner region enclosed by the arms 1, 2. Any fringe fields at the joints 3, 4 are prevented from straying into the housing by means of the magnetic circuit of the cuffs 6, 7 surrounding the outer faces of the joints 3, 4. Hence the magnetic fields sensed in the sensors 12, 13 arises solely from the current to be sensed/measured within the inner region. The signal generated by the sensors 12, 13 (a Hall effect current in this embodiment) is sensed and/or measured by electronic ammeter sensing circuitry (not shown).

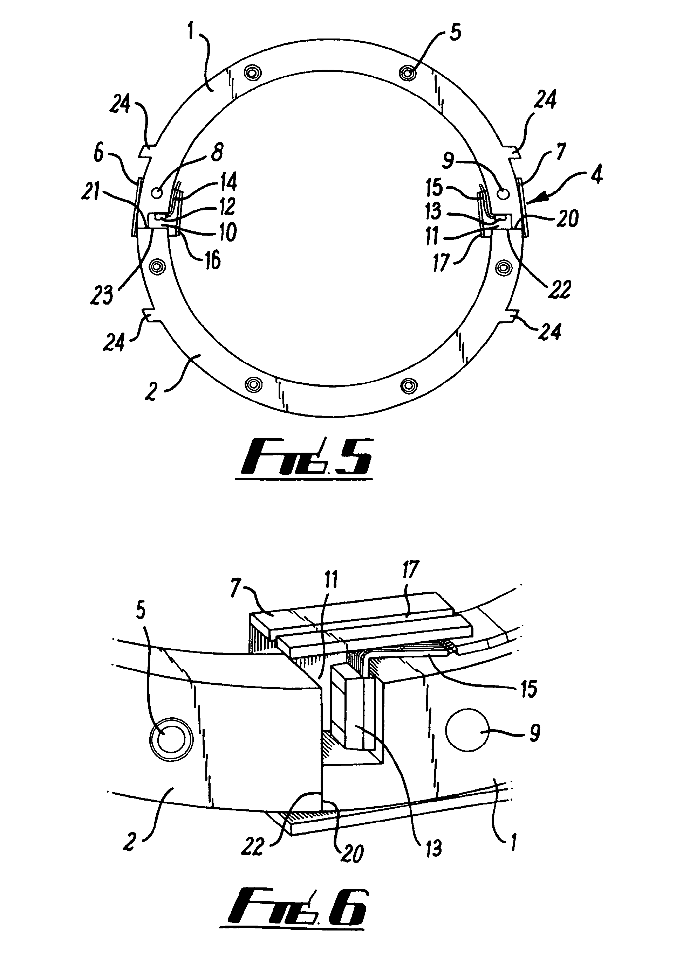

Turning to Figures 5 and 6, these show a second embodiment of the current sensing assembly of the first aspect of the invention. The arrangement is substantially the same as for the first embodiment shown in Figures 1 to 4, but when the arms 1, 2 are in the closed configuration, no gaps 18, 19 are present between the ends 20, 21 of the first arm and the ends 22, 23 of the second arm in this second embodiment. In this embodiment, lugs 24 are provided on each arm 1, 2 in order to allow the arms to be firmly fixed to holders (not shown) which hold the arms. The closed configuration is made by bringing the holders, holding the arms, into touching contact with each other such that the ends 20, 21 of arm 1 are brought into touching contact with the ends 22, 23 of arm 2.

In use, the second embodiment is employed as for the first embodiment.

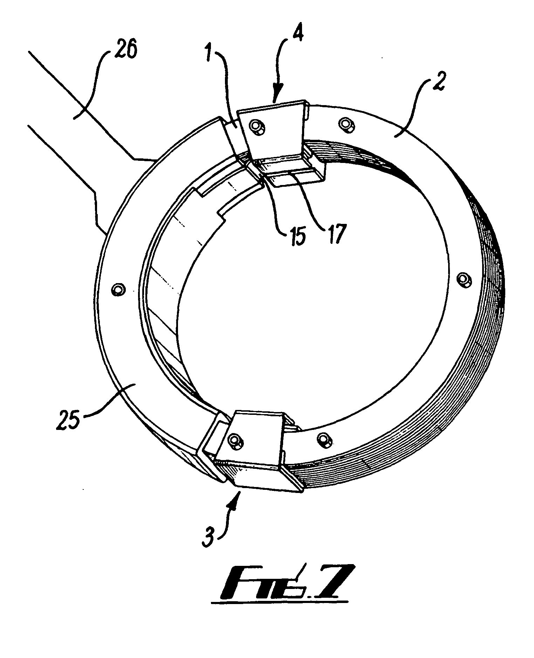

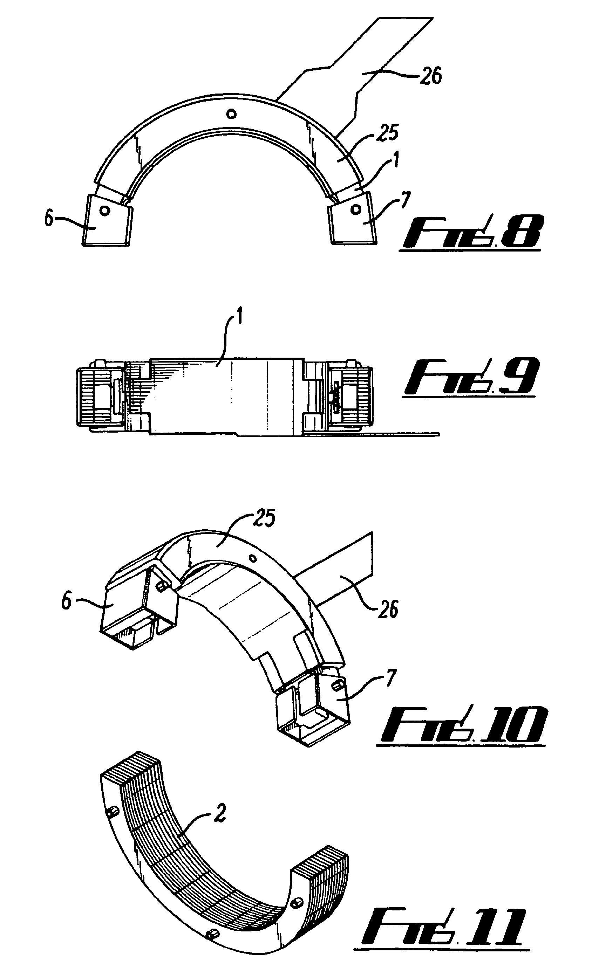

Figures 7 to 11 show a third embodiment of the invention. This is an embodiment as for the first embodiment of the invention, but with a compensation coil 25 affixed as a sleeve on the first arm 1. The compensation coil 25 is a means for generating a compensating magnetic field at the magnetic sensors. It has a winding enclosed in a protective sleeve. A compensating current is passed through the winding to generate the compensating magnetic field. In use, the arms 1,2 are brought into a closed configuration, as for the first embodiment, to encircle a cable or wire carrying a current to be measured. The magnetic field generated by the current to be measured gives rise to a magnetic field at each magnetic sensor 12, 13 and a signal (Hall-effectvoltage) is send along the leads 14, 15 and along a connection cable 26 to a control and measurement means (not shown). The control and measurement means will typically be a computercontrolled apparatus such as a PID controller (proportional/integral/differential) as is well known in the art. In response to the signals from each magnetic sensor, the control and measurement means generates a compensation current, sent back through the connection cable 26, to pass through the windings of the compensation coil 25 in order to provide a reverse magnetic field to that generated by the current to be measured. The control and measurement means adjusts the compensation current value such that the arithmetic mean of the signals from the sensors 12, 13 is a minimum. The value of the current to be sensed can thus be derived from the compensation current value by means of a calibration curve. Alternatively analogue electronic techniques may be used to generate and detect the compensation current.

It will be appreciated that numerous modifications to the above described embodiment may be made without departing from the scope of the invention as defined in the appended claims. For example, in the first embodiment, the gaps 18, 19 between the ends of the arms 1,2 may be due to thin varnish layers on the end of one or both arms. For example, in the third embodiment, a compensation coil 25 may be provided on each arm 1, 2. for example, flux gate sensors may be used instead of Hall-effect sensors.

The described and illustrated embodiments are to be considered as illustrative and not restrictive in character, it being understood that only the preferred embodiments have been shown and described and that all changes and modifications that come within the scope of the inventions as defined in the claims are desired to be protected. It should be understood that while the use of words such as "preferable", "preferably", "preferred" or "more preferred" in the description suggest that a feature so described may be desirable, it may nevertheless not be necessary and embodiments lacking such a feature may be contemplated as within the scope of the invention as defined in the appended claims. In relation to the claims, it is intended that when words such as "a," "an," "at least one," or "at least one portion" are used to preface a feature there is no intention to limit the claim to only one such feature unless specifically stated to the contrary in the claim. When the language "at least a portion" and/or "a portion" is used the item can include a portion and/or the entire item unless specifically stated to the contrary.

## Claims

1. A current sensing assembly comprising first and second arms (1, 2) of a first magnetically permeable material,
each having first (21, 23) and second ends (20, 22),
the arms being configured to be movable from an open configuration to a closed configuration,
wherein, in the closed configuration, the first ends (21, 23) of each arm (1, 2) are positioned at a first joint (3) and the second ends (20, 22) of each arm (1, 2) are positioned at a second joint (4),
and wherein in the closed configuration, the arms (1, 2) and joints (3, 4) co-operate to form a substantially closed magnetic circuit defining an inner region enclosed by the magnetic circuit suitable for accepting a cable in which an electrical current is to be sensed,
**characterised in that** a first magnetic field sensor (12) is located in a first housing (10) at the first joint (3), and the first joint (3) is provided with a cuff (6) of a second magnetically permeable material arranged and positioned to enclose the first joint (3), when in the closed configuration, save for an aperture (16) in the cuff (6) positioned between the first magnetic field sensor (12) and the inner region, and to shield the first magnetic field sensor (12) from magnetic fields originating outside the inner region.

2. A current sensing assembly according to claim 1 wherein a second magnetic field sensor (13) is located in a second housing (11) at the second joint (4), the second joint (4) being provided with a second cuff (7) of the second magnetically permeable material arranged and positioned to enclose the second joint (4), when in the closed configuration, save for an aperture (17) in the second cuff (7) positioned between the second magnetic field sensor (13) and the inner region, and to shield the second magnetic field sensor (13) from magnetic fields originating outside the inner region.

3. A current sensing assembly according to claim 2 wherein the first cuff (6) and second cuff (7) are each affixed to the first and second ends (21, 20) respectively of the first arm (1), and wherein the first and second housings (10, 11) are positioned in the first and second ends (21, 20) of the first arm (1).

4. A current sensing assembly according to any preceding claim wherein each first and second arm (1, 2) is substantially semicircular in shape.

5. A current sensing assembly according to any preceding claim wherein the second joint (4) comprises a pivot means whereby the arms are movable from an open configuration to a closed configuration about the pivot means.

6. A current sensing assembly according to any preceding claim wherein, in the closed configuration, the first ends (21, 23) are in touching contact with each other and the second ends (20, 22) are in touching contact with each other whereby the magnetic circuit is substantially uninterrupted at the first and second joints (3, 4).

7. A current sensing assembly according to any one of claims 2 to 5 wherein, in the closed configuration, there is a first gap (18) between the first ends (21, 23) and a second gap (19) between the second ends (20,22) whereby the magnetic circuit comprises first and second reluctances arising from the first and second gaps (18, 19) respectively.

8. A current sensing assembly according to claim 7 wherein the first and second reluctances are each 10⁴ Ampere-turns/Weber or more.

9. A current sensing assembly according to claim 7 or claim 8 wherein the first and second joints (3, 4) comprise first and second spacing means arranged to give rise to the first and second gaps (18, 19) in the closed configuration.

10. A current sensing assembly according to any preceding claim wherein the first and second magnetic field sensors (12, 13) are Hall effect sensors.

11. A current sensing assembly according to any preceding claim wherein the current sensing assembly comprises a means (25) for generating a compensating magnetic field, driven by a compensation current, within the magnetic circuit whereby a net magnetic field at each magnetic field sensor (12, 13), originating from a current to be measured in a cable passing through the inner region, combined with the compensating magnetic field, may be minimised such that said current to be measured has a value deducible from the required compensation current value.

12. A current sensing device comprising a current sensing assembly according to any preceding claim.

13. A current sensing device according to claim 12 comprising an actuating means configured to move the first and second arms (1, 2) between open and closed configurations.

14. A method for sensing and/or measuring a current in a cable comprising:
configuring the cable to pass through the inner region of a current sensing assembly or device according to any one of claims 1 to 13,
sensing or measuring the magnetic field generated by the current using the first and optionally second magnetic field sensor (12, 13), whereby the current is sensed or measured.

15. A method according to claim 14 wherein the current sensing assembly is according to claim 11 and the wherein the current value is deduced from the compensating current value required to minimise the net magnetic field at the first and optionally second magnetic field sensor (12, 13).

## Patentansprüche

1. Stromerfassungsbaugruppe, die einen ersten und einen zweiten Arm (1, 2) aus einem ersten magnetisch permeablen Werkstoff umfasst,
die jeder ein erstes (21, 23) und ein zweites Ende (20, 22) haben,
wobei die Arme so konfiguriert sind, dass sie von einer offenen Konfiguration zu einer geschlossenen Konfiguration bewegt werden können,
wobei, in der geschlossenen Konfiguration, die ersten Enden (21, 23) jedes Arms (1, 2) an einer ersten Verbindungsstelle (3) angeordnet sind und die zweiten Enden (20, 22) jedes Arms (1, 2) an einer zweiten Verbindungsstelle (4) angeordnet sind,
und wobei in der geschlossenen Konfiguration die Arme (1, 2) und die Verbindungsstellen (3, 4) zusammenwirken, um einen im Wesentlichen geschlossenen magnetischen Kreis zu bilden, der einen durch den magnetischen Kreis umschlossenen inneren Bereich definiert, der dafür geeignet ist, ein Kabel aufzunehmen, in dem ein elektrischer Strom erfasst werden soll,
**dadurch gekennzeichnet, dass** ein erster Magnetfeldsensor (12) in einem ersten Gehäuse (10) an der ersten Verbindungsstelle (3) angeordnet ist und die erste Verbindungsstelle (3) mit einer Manschette (6) aus einem zweiten magnetisch permeablen Werkstoff versehen ist, die so angeordnet und positioniert ist, dass sie die erste Verbindungsstelle (3) umschließt, wenn sie sich in der geschlossenen Konfiguration befindet, mit Ausnahme einer Öffnung (16) in der Manschette (6), die zwischen dem ersten Magnetfeldsensor (12) und dem inneren Bereich angeordnet ist, und den ersten Magnetfeldsensor (12) von Magnetfeldern, die von außerhalb des inneren Bereichs stammen, abschirmt.

2. Stromerfassungsbaugruppe nach Anspruch 1, wobei ein zweiter Magnetfeldsensor (13) in einem zweiten Gehäuse (11) an der zweiten Verbindungsstelle (4) angeordnet ist, wobei die zweite Verbindungsstelle (4) mit einer zweiten Manschette (7) aus dem zweiten magnetisch permeablen Werkstoff versehen ist, die so angeordnet und positioniert ist, dass sie die zweite Verbindungsstelle (4) umschließt, wenn sie sich in der geschlossenen Konfiguration befindet, mit Ausnahme einer Öffnung (17) in der zweiten Manschette (7), die zwischen dem zweiten Magnetfeldsensor (13) und dem inneren Bereich angeordnet ist, und den zweiten Magnetfeldsensor (13) von Magnetfeldern, die von außerhalb des inneren Bereichs stammen, abschirmt.

3. Stromerfassungsbaugruppe nach Anspruch 2, wobei die erste Manschette (6) und die zweite Manschette (7) jeweils an dem ersten beziehungsweise dem zweiten Ende (21, 20) des ersten Arms (1) befestigt sind und wobei das erste und das zweite Gehäuse (10, 11) in dem ersten beziehungsweise dem zweiten Ende (21, 20) des ersten Arms (1) positioniert sind.

4. Stromerfassungsbaugruppe nach einem der vorhergehenden Ansprüche, wobei jeder erste und zweite Arm (1, 2) im Wesentlichen von halbkreisförmiger Gestalt ist.

5. Stromerfassungsbaugruppe nach einem der vorhergehenden Ansprüche, wobei die zweite Verbindungsstelle (4) ein Schamiermittel umfasst, wodurch die Arme von einer offenen Konfiguration zu einer geschlossenen Konfiguration um das Scharniermittel bewegt werden können.

6. Stromerfassungsbaugruppe nach einem der vorhergehenden Ansprüche, wobei, in der geschlossenen Konfiguration, sich die ersten Enden (21, 23) in Berührungskontakt miteinander befinden und sich die zweiten Enden (20, 22) in Berührungskontakt miteinander befinden, wodurch der magnetische Kreis im Wesentlichen an der ersten und der zweiten Verbindungsstelle (3, 4) nicht unterbrochen ist.

7. Stromerfassungsbaugruppe nach einem der Ansprüche 2 bis 5, wobei es, in der geschlossenen Konfiguration, einen ersten Spalt (18) zwischen den ersten Enden (21, 23) und einen zweiten Spalt (19) zwischen den zweiten Enden (20, 22) gibt, wodurch der magnetische Kreis eine erste und eine zweite Reluktanz umfasst, die sich jeweils aus dem ersten beziehungsweise dem zweiten Spalt (18, 19) ergeben.

8. Stromerfassungsbaugruppe nach Anspruch 7, wobei die erste und die zweite Reluktanz jeweils 10⁴ Amperewindungen/Weber oder mehr betragen.

9. Stromerfassungsbaugruppe nach Anspruch 7 oder Anspruch 8, wobei die erste und die zweite Verbindungsstelle (3, 4) erste und zweite Abstandsmittel umfassen, die so angeordnet sind, dass sie in der geschlossenen Konfiguration den ersten und den zweiten Spalt (18, 19) entstehen lassen.

10. Stromerfassungsbaugruppe nach einem der vorhergehenden Ansprüche, wobei der erste und der zweite Magnetfeldsensor (12, 13) Hall-Effekt-Sensoren sind.

11. Stromerfassungsbaugruppe nach einem der vorhergehenden Ansprüche, wobei die Stromerfassungsbaugruppe ein Mittel (25) zum Erzeugen eines kompensierenden Magnetfeldes, angesteuert durch einen Kompensationsstrom, innerhalb des magnetischen Kreises umfasst, wodurch ein Nettomagnetfeld an jedem Magnetfeldsensor (12, 13), das sich aus einem zu messenden Strom in einem durch den inneren Bereich hindurchgehenden Kabel, kombiniert mit dem kompensierenden Magnetfeld, ergibt, minimiert werden kann derart, dass der zu messende Strom einen Wert hat, der aus dem Wert des erforderlichen Kompensationsstroms abgeleitet werden kann.

12. Stromerfassungsvorrichtung, die eine Stromerfassungsbaugruppe nach einem der vorhergehenden Ansprüche umfasst.

13. Stromerfassungsvorrichtung nach Anspruch 12, die ein Betätigungsmittel umfasst, das so konfiguriert ist, dass es den ersten und den zweiten Arm (1, 2) zwischen offenen und geschlossenen Konfigurationen bewegt.

14. Verfahren zum Erfassen und/oder Messen eines Stroms in einem Kabel, die Folgendes umfasst:
das Konfigurieren des Kabels so, dass es durch den inneren Bereich einer Stromerfassungsbaugruppe oder -vorrichtung nach einem der Ansprüche 1 bis 13 hindurchgeht,
das Erfassen oder Messen des durch den Strom erzeugten Magnetfeldes unter Verwendung des ersten und wahlweise des zweiten Magnetfeldsensors (12, 13), wodurch der Strom erfasst oder gemessen wird.

15. Verfahren nach Anspruch 14, wobei die Stromerfassungsbaugruppe nach Anspruch 11 ist und wobei der Stromwert aus dem Wert des Kompensationsstroms abgeleitet wird, der erforderlich ist, um das Nettomagnetfeld an dem ersten und wahlweise dem zweiten Magnetfeldsensor (12, 13) zu minimieren.

## Revendications

1. Assemblage de détection de courant, comprenant des premier et deuxième bras (1, 2) composés d'un premier matériau à perméabilité magnétique ;
comportant chacun des première (21, 23) et deuxième extrémités (20, 22) ;
les bras étant configurés de sorte à pouvoir être déplacés d'une configuration ouverte vers une configuration fermée ;
dans lequel, dans la configuration fermée, les premières extrémités (21, 23) de chaque bras (1, 2) sont positionnées au niveau d'un premier joint (3), les deuxièmes extrémités (20, 22) de chaque bras (1, 2) étant positionnées au niveau d'un deuxième joint (4) ;
et dans lequel, dans la configuration fermée, les bras (1, 2) et les joints (3, 4) coopèrent pour former un circuit magnétique essentiellement fermé, définissant une région interne renfermée par le circuit magnétique, appropriée pour recevoir un câble dans lequel un courant électrique doit être détecté ;
**caractérisé en ce qu'**un premier capteur de champ magnétique (12) est agencé dans un premier boîtier (10), au niveau du premier joint (3), le premier joint (3) comportant un manchon (6) composé d'un deuxième matériau à perméabilité magnétique, agencé et positionné de sorte à renfermer le premier joint (3), dans la configuration fermée, à l'exception d'une ouverture (16) dans le manchon (6), positionnée entre le premier capteur de champ magnétique (12) et la région interne, et à assurer le blindage du premier capteur de champ magnétique (12) par rapport à des champs magnétiques provenant de l'extérieur de la région interne.

2. Assemblage de détection de courant selon la revendication 1, dans lequel un deuxième capteur de champ magnétique (13) est agencé dans un deuxième boîtier (11), au niveau du deuxième joint (4), le deuxième joint (4) comportant un deuxième manchon (7), composé du deuxième matériau à perméabilité magnétique, agencé et positionné de sorte à renfermer le deuxième joint (4), dans la configuration fermée, à l'exception d'une ouverture (17) dans le deuxième manchon (7), positionnée entre le deuxième capteur de champ magnétique (13) et la région interne, et à assurer le blindage du deuxième capteur de champ magnétique (13) par rapport à des champs magnétiques provenant de l'extérieur de la région interne.

3. Assemblage de détection de courant selon la revendication 2, dans lequel le premier manchon (6) et le deuxième manchon (7) sont respectivement chacun fixés sur les première et deuxième extrémités (21, 20) du premier bras (1), les premier et deuxième boîtiers (10, 11) étant positionnés dans les première et deuxième extrémités (21, 20) du premier bras (1).

4. Assemblage de détection de courant selon l'une quelconque des revendications précédentes, dans lequel chaque premier et deuxième bras (1, 2) a une forme essentiellement semi-circulaire.

5. Assemblage de détection de courant selon l'une quelconque des revendications précédentes, dans lequel le deuxième joint (4) comprend un moyen de pivot, les bras pouvant ainsi être déplacés d'une configuration ouverte vers une configuration fermée autour du moyen de pivot.

6. Assemblage de détection de courant selon l'une quelconque des revendications précédentes, dans lequel, dans la configuration fermée, les premières extrémités (21, 23) sont en contact par attouchement l'une avec l'autre, les deuxièmes extrémités (20, 22) étant en contact par attouchement l'une avec l'autre, le circuit magnétique étant ainsi essentiellement ininterrompu au niveau des premier et deuxième joints (3, 4).

7. Assemblage de détection de courant selon l'une quelconque des revendications 2 à 5, dans lequel, dans la configuration fermée, un premier espace (18) est établi entre les premières extrémités (21, 23), un deuxième espace (19) étant établi entre les deuxièmes extrémités (20, 22), le circuit magnétique comprenant ainsi des première et deuxième réluctances émanant respectivement des premier et deuxième espaces (18, 19).

8. Assemblage de détection de courant selon la revendication 7, dans lequel les première et deuxième réluctances correspondent chacune à 10⁴ Ampères-tours/Weber ou plus.

9. Assemblage de détection de courant selon les revendications 7 ou 8, dans lequel les premier et deuxième joints (3, 4) comprennent des premier et deuxième moyens d'espacement, agencées de sorte à établir les premier et deuxième espaces (18, 19) dans la configuration fermée.

10. Assemblage de détection de courant selon l'une quelconque des revendications précédentes, dans lequel les premier et deuxième capteurs de champ magnétique (12, 13) sont des capteurs à effet Hall.

11. Assemblage de détection de courant selon l'une quelconque des revendications précédentes, dans lequel l'assemblage de détection de courant comprend un moyen (25) pour former un champ magnétique de compensation, entraîné par un courant de compensation, dans le circuit magnétique, un champ magnétique net au niveau de chaque capteur de champ magnétique (12, 13), provenant d'un courant devant être mesuré dans un câble passant à travers la région interne, combiné avec le champ magnétique de compensation, pouvant ainsi être réduit au minimum, de sorte que ledit courant devant être mesuré a une valeur pouvant être déduite de la valeur du courant de compensation requis.

12. Dispositif de détection de courant, comprenant un assemblage de détection de courant selon l'une quelconque des revendications précédentes.

13. Dispositif de détection de courant selon la revendication 12, comprenant un moyen d'actionnement, configuré de sorte à déplacer les premier et deuxième bras (1, 2) entre des configurations ouverte et fermée.

14. Procédé de détection et/ou de mesure d'un courant dans un câble, comprenant les étapes ci-dessous :
configuration du câble pour permettre son passage à travers la région interne d'un assemblage ou d'un dispositif de détection de courant selon l'une quelconque des revendications 1 à 13 ;
détection ou mesure du champ magnétique généré par le courant par l'intermédiaire du premier, et optionnellement du deuxième capteur de champ magnétique (12, 13), le courant étant ainsi détecté ou mesuré.

15. Procédé selon la revendication 14, dans lequel l'assemblage de détection de courant est conforme à la revendication 11, la valeur du courant étant déduite de la valeur du courant de compensation requis pour réduire au minimum le champ magnétique net au niveau du premier, et optionnellement du deuxième capteur de champ magnétique (12, 13).
